# EUROPÄISCHE PATENTANMELDUNG

(11) **EP 1 452 260 A1**
(43) Veröffentlichungstag der Anmeldung: **01.09.2004**
(21) Anmeldenummer: 03004158.6
(22) Anmeldetag: 26.02.2003
(51) Int. Cl.: B23K 1/20

(54) **Vorrichtung und Verfahren zum Aufbringen eines Flussmittels für das Hartlöten von Teilen**

(71) Anmelder: Behr GmbH & Co., 70469 Stuttgart (DE); Frape Behr S.A., 08040 Barcelona (ES)
(72) Erfinder: Englert, Peter, Dipl.-Ing, 74177 Bad Friedrichshall (DE); Trautwein, Ingo, 74321 Bietigheim-Bissingen (DE); Ferrer, Joan, 08030 Barcelona (ES); Sabetta, Vincenzo, 08860 Castelldefels (ES)
(74) Vertreter: Grauel, Andreas, Dr.

(57) **Zusammenfassung**

Die Erfindung betrifft eine Vorrichtung und ein Verfahren zum vorzugsweise ungleichmässigen Aufbringen von Flussmittel auf eine Materialoberfläche, insbesondere auf die wellrippenseitige Seite einer Scheibe von einem Scheibenkühler.

## Beschreibung

Die Erfindung betrifft eine Vorrichtung und ein Verfahren zum Aufbringen eines Flussmittels zum Hartlöten von Teilen, insbesondere zur Herstellung von Scheibenkühlern, wie sie in Kraftfahrzeugen verwendet werden, gemäß dem Oberbegriff des Anspruchs 1 bzw. 3 bzw. 13 bzw. 14. Die Erfindung betrifft weiterhin einen Wärmetauscher unter Verwendung eines entsprechenden Verfahrens.

Zum Hartlöten lotplattierter Einzelteile insbesondere für Wärmetauscher, d.h. insbesondere von Kühlern, Verdampfern, Kondensatoren etc. wie sie in der Automobilbranche verwendet werden, ist es bei Verwendung von Aluminium bzw. Aluminiumlegierungen als Grundmaterial derzeit üblich, spezielle Lötverfahren einzusetzen, insbesondere das sogenannte NOCOLOK®-Löten.

Dieses ist im Grundsatz in der DE-OS 26 14 872 als ein Verfahren zum Verbinden von Aluminiumkomponenten mit einer Aluminiumlötlegierung mit einem Schmelzpunkt unter dem der Aluminiumkomponenten, durch Erwärmen der zusammengesetzten Komponenten auf eine Temperatur über dem Schmelzpunkt der Lötlegierung und unter dem Schmelzpunkt der Komponenten in Anwesenheit eines Kaliumfluoaluminatschmelzmittels, das im wesentlichen frei von nicht umgesetztem KF ist, beschrieben. Dieses bekannte Verfahren zeichnet sich dadurch aus, dass das Schmelzmittel und die Lötlegierung auf de Oberflächen von mindestens einer der Komponenten als wässrige Aufschlämmung aus feinverteiltem Schmelzmittel und Metallpulver aufgetragen werden, der Aufschlämmungsfilm getrocknet wird und die stofffreien Inertgasatmosphäre (gegebenenfalls nach dem Zusammensetzen) verlötet werden, wobei die Anwendung der Schmelzmittel/Lötlegierungsaufschlämmung so gesteuert wird, dass 40 bis 150 g/m² angewendet werden und das Verhältnis von Schmelzmittel zu Lötlegierung so ausgewählt wird, dass mindestens 5 g/m² Schmelzmittel abgeschieden werden.

Wegen der speziellen Materialeigenschaften des Aluminiums bzw. der Aluminiumlegierungen ist bei dem genannten Lötverfahren das Aufbringen eines nicht korrosiven, nicht hygroskopischen Flussmittels notwendig. Beim NOCOLOK®-Löten (CAB-Lötung) wird dafür ein Flussmittel auf der Basis von Kaliumfluoaluminat mit der Summenformel K₍₁₋₃₎AlF₍₄₋₆₎ verwendet. Dieses Flussmittel liegt als Eutektikum vor, schmilzt bei einer Temperatur von 562°C bis 572°C und entfernt das auf dem Aluminium als solchem stets als Oberflächenverunreinigung vorhandene Aluminiumoxid. Dadurch wird für kurze Zeit die Oberfläche des AI-Materials weiteren Bearbeitungsschritten, wie dem Hartlöten, zugänglich gemacht, was man fachspezifisch auch mit "Aktivierung der Oberfläche" bezeichnet.

Das vorstehend erwähnte nicht hygroskopische Flussmittel benetzt die Oberfläche und das Lot kann, wenn die Lotplattierung bei einer Temperatur von 577°C zu schmelzen beginnt, durch Kapillarwirkung frei in die Lötspalte gezogen werden. Ohne einen der Lötsituation angemessenen Flussmittelauftrag ist also keine fertigungssichere, Komplettdicht-Lötung möglich.

Üblicherweise wird das genannte Flussmittel auf folgende Arten aufgebracht, was fachsprachlich als Befluxung bezeichnet wird:
a) Indem flächig mit Hilfe einer Sprühbefluxungseinrichtung als wässrige Suspension aufgesprüht wird, gefolgt von Ausblasen der Netze und anschließende Trocknung;
b) indem eine wässrige Suspension aufgepinselt wird, gefolgt von anschließender Trocknung; und
c) indem das Flussmittel lokal mittels einer Kanüle als pastöse Suspension in verschiedenen Glykolen und/oder Glykolethern aufgetragen wird, gefolgt von anschließender Trocknung.

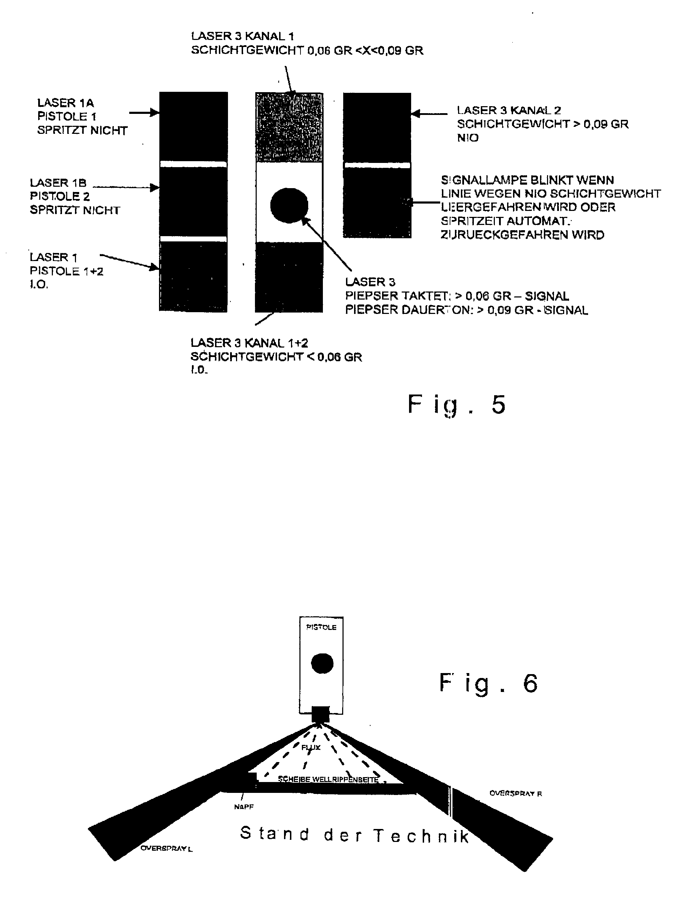

Die mit a) bezeichnete Variante des Aufbringens des Flussmittels wird hauptsächlich bei der Befluxung von Wärmetauschernetzen, bei der Wellrippen-/Rohr-Verlötung oder, wie in Fig. 6 dargestellt, bei der Befluxung von Scheiben beispielsweise für einen Scheibenkühler oder Scheibenverdampfer angewandt. Hierbei wird normalerweise das Werkstück mit Hilfe einer mittig zum Werkstück bzw. dessen Transportrichtung angeordneten Sprühpistole in einem rechten Winkel besprüht, wobei der Sprühstrahl derart bemessen und ausgebildet ist, das beidseitig, das heißt rechts und links von der Mitte des Werkstücks, ein "Overspray" vorhanden ist, d.h. dass der Sprühstrahl breiter als eigentlich erforderlich ausgebildet ist. Der Sprühstrahl führt zu einer gleichmäßig dicken Besprühung mit Flussmittel.

Die herkömmliche Befluxung lässt jedoch noch Wünsche offen, insbesondere kann eine Überdosierung von Flussmittel auftreten, was zu erhöhten Kosten führt.

Es ist Aufgabe der Erfindung, eine verbesserte Vorrichtung zum Aufbringen von Flussmittel zur Verfügung zu stellen. Weiterhin ist es Aufgabe, ein Verfahren zu schaffen, zur optimaleren Befluxung. Auch ist es die Aufgabe, Wärmeübertrager zu schaffen, die eine optimierte Befluxung aufweisen.

Diese Aufgabe wird gelöst durch eine Vorrichtung mit den Merkmalen des Anspruchs 1. Diese Aufgabe wird weiterhin gelöst durch eine Vorrichtung mit den Merkmalen des Anspruchs 3. Diese Aufgabe wird weiterhin gelöst durch ein Verfahren mit den Merkmalen des Anspruchs 13. Diese Aufgabe wird weiterhin gelöst durch ein Verfahren mit den Merkmalen des Anspruchs 14. Die erfindungsgemäße Aufgabe wird auch durch Wärmetauscher gemäß Anspruch 18 erreicht. Vorteilhafte Ausgestaltungen sind Gegenstand der Unteransprüche.

Erfindungsgemäß ist eine Vorrichtung mit einer Befluxungs-Vorrichtung zum automatisierten Aufbringen von Flussmittel auf eine Materialoberfläche mit einer Sprühvorrichtung, wie beispielsweise Sprühdüse oder Sprühpistole, die in einem Winkel von 30° bis 60° zur Materialoberfläche, bevorzugt in einem Winkel von etwa 40°, geneigt, in einem Bereich in der Nähe eines Randes der Materialoberfläche angeordnet ist, vorgesehen.

Diese dient insbesondere zum gezielten Besprühen von Scheiben eines Scheibenwärmetauschers mit Flussmittel, wobei die mit Flussmittel versehenen Materialoberflächen anschließend mittels NOCOLOK®-Löten mit entsprechend behandelten anderen Materialoberflächen verbunden werden.

Aus der älteren Anmeldung DE 101 41 883, deren Offenbarung hiermit ausdrücklich zum Offenbarungsgehalt der vorliegenden Anmeldung einbezogen wird, sind Flussmittelzusammensetzung bekannt, die bevorzugt für das erfindungsgemäße Verfahren verwendet werden können.

Bevorzugt ist die Materialoberfläche horizontal angeordnet. Hierbei liegt die zu befluxende Scheibe bevorzugt mit ihrer Wellrippenseite nach oben auf einer Transportvorrichtung, beispielsweise einem Transportband, und durch läuft nacheinander verschiedene Stationen, wie eine Besprühstation, eine Trockenstation, eine Kontrollstation. Die Sprühpistole ist leicht seitlich versetzt gegenüber der Scheibe in der Nähe eines napfförmigen Bereichs der Scheibe, der sich in der Nähe eines Randes der Scheibe befindet, angeordnet.

Bei einem Ausführungsbeispiel der Erfindung kann die Anordnung der Sprühvorrichtung derart gewählt werden, daß das Bauteil derart besprüht oder beschichtet wird, daß die für eine Dichtlötung erforderliche höhere Flussmittelmenge in einem definierten Bereich des Bauteils aufgebracht wird und in einem anderen Bereich des Bauteils eine dagegen reduzierte Menge des Flussmittels, beispielsweise für die Wellrippenverlötung, aufgebracht wird.

Bevorzugt weist die Vorrichtung eine Überwachungsvorrichtung auf, welche der Kontrolle der Flussmittelbeschichtung dient. Diese Überwachungsvorrichtung wird vorzugsweise durch eine oder mehrere Überwachungs-Einheiten gebildet, die beispielsweise den Sprühstrahl und insbesondere auch das Vorhandensein einer ausreichenden und nicht zu starken Flussmittelbeschichtung in einem oder mehreren definierten Bereichen des Bauteils überwachen.

Bevorzugt ist die Überwachungsvorrichtung eine optische Überwachungsvorrichtung. Dies hat den Vorteil einer präzisen und dennoch schnellen Überwachung in der Produktion bei einer hohen Prozeßgeschwindigkeit. Dies kann insbesondere eine Laservorrichtung mit zumindest einem Sender und zumindest einem Empfänger sein. Bevorzugt ist ein 2-Kanal-Laser vorgesehen, der die Schichtdicke oder Schichtgewicht , die bevorzugt in einem Bereich von 0,01 bis 0,15 g/cm² und insbesondere vorzugsweise im Bereich von 0,02 bis 0,1 g/cm² liegt, überwacht.

Im folgenden wird die Erfindung anhand eines Ausführungsbeispiels unter Bezugnahme auf die Zeichnung im einzelnen erläutert. In der Zeichnung zeigen:
- Fig. 1: eine schematische Darstellung einer erfindungsgemäßen wellrippenseitigen Befluxung einer Scheibe für einen Scheibenkühler,
- Fig. 2: eine Überwachungsvorrichtung für den Befluxungsvorgang von Fig. 1,
- Fig. 3: eine zweite Überwachungsvorrichtung,
- Fig. 4: eine dritte Überwachungsvorrichtung,
- Fig. 5: eine Ampelanlage zur Überwachung der einzelnen Überwachungsvorrichtungen, und
- Fig. 6: eine schematische Darstellung einer erfindungsgemäßen wellrippenseitigen Befluxung einer Scheibe für einen Scheibenkühler gemäß dem Stand der Technik.

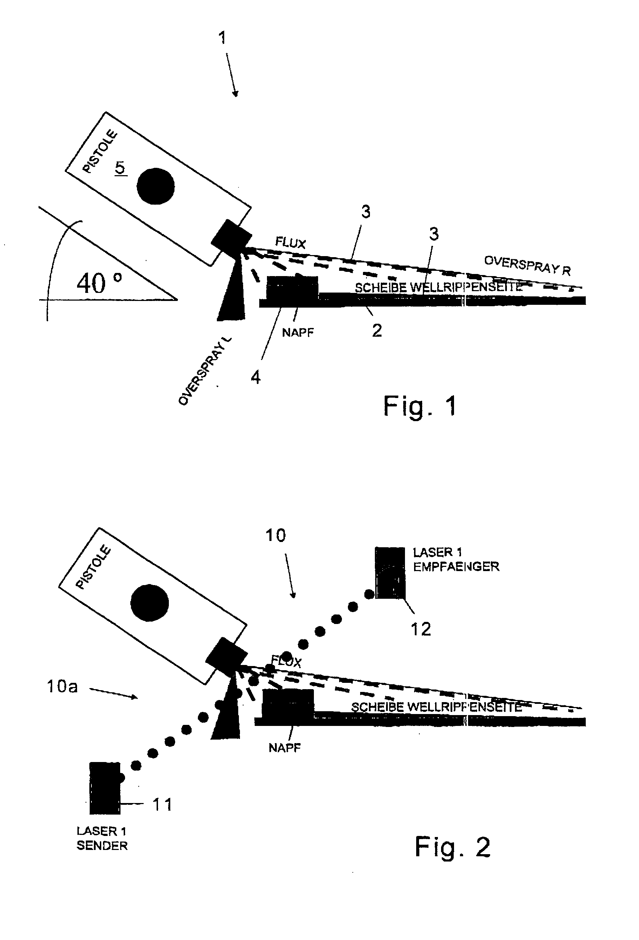

Fig. 1 zeigt den Vorgang der Befluxung, d.h. des Versehen mit Flussmittel, mit Hilfe einer automatisierten Befluxungs-Vorrichtung 1. Hierbei wird ein Werkstück 2 auf einer Seite mit einem Flussmittel 3 besprüht. Beim Werkstück 2 handelt es sich vorliegend um eine Scheibe für einen Scheibenkühler, wie er in Kraftfahrzeugen verwendet wird, mit einer Wellrippenseite und einer Noppenseite. Die in Fig. 1 dargestellte Befluxungsvorrichtung 1 besprüht die Scheibe wellrippenseitig. Die Scheibe wird flach liegend mittels einer nicht dargestellten Transportvorrichtung, beispielsweise mittels eines Transportbandes, in Blickrichtung von Fig. 1 transportiert, wobei die zu besprühende Wellrippenseite der Scheibe nach oben zeigt. Der Besprühvorgang erfolgt getaktet.

Die Scheibe weist einen napfförmigen Bereich 4 auf, der in den Figuren 1 bis 4 mit "Napf" bezeichnet ist, welcher mit entsprechend ausgebildeten napfförmigen Bereichen anderer Scheiben dicht verlötet werden soll. Dieser napfförmige Bereich 4 ist seitlich in der Nähe des Randes der Scheibe angeordnet. Die Scheibe ist derart auf der Transportvorrichtung angeordnet, dass der napfförmige Bereich 4 auf einer Seite derselben liegt.

Um die sichere Verlötung sicherzustellen, ist erfindungsgemäß eine Sprühvorrichtung, wie Sprühdüse oder Sprühpistole, 5 mit einer das zu versprühende Flussmittel 3 als aufgefächerten Sprühstrahl versprühenden Sprühvorrichtung, wie Sprühdüse oder Sprühpistole, in einem Winkel von etwa 40° zur Horizontalen angeordnet. Der Sprühstrahl mit Flussmittel 3 aus der Sprühpistole 5 ist derart aufgefächert ausgebildet, dass rechts und links über das Werkstück 2 hinaus gesprüht wird ("Overspray L" und "Overspray R"). Die Kernzone des Sprühstrahls trifft hierbei auf den napfförmigen Bereich 4 der Scheibe, der in der Nähe der Sprühpistole 5 angeordnet ist.

Das als "Overspray R" versprühte Flussmittel 3, welches im wesentlichen nebelartig vorliegt, wird dazu genutzt, die Wellrippenverlötung ausreichend zu garantieren. Zuviel versprühtes Flussmittel 3, insbesondere das als "Overspray L" versprühte Flussmittel 3, wird mittels Trichter o.ä. unterhalb gesammelt und wieder dem wellrippseitigen Flussmittel-Kreislauf zugeführt.

Durch das zuvor beschriebene Verfahren wird die Menge Flussmittel je Fläche auf der wellrippenseitigen Seite der Scheibe auf einen definierten Wert von ca. 0,01 bis 0,15 g/cm², insbesondere von ca. 0,02 bis 0,09 g/cm², reduziert, wobei dennoch eine sichere Verlötung sichergestellt wird.

Die Befluxung der Noppenseite, d.h. der der Wellrippenseite gegenüberliegenden, in den Figuren nach unten zeigenden Seite der Scheibe, erfolgt mittels einer zweiten, nicht in der Figur dargestellten Befluxungs-Vorrichtung über einen getrennten Kreislauf, da die Pumpenund Sprühvorrichtungseinstellung für die wellrippenseitige Beschichtung gegenüber der anderen Seite auf einen anderen, vorzugsweise geringeren Wert eingestellt sein sollte. Die noppenseitige Befluxungs-Vorrichtung kann auf herkömmliche Weise ausgebildet sein. Es kann aber auch vorteilhaft sein, eine ungleichmässige, heterogene, Befluxung oder Beschichtung auf dieser Seite vorzunehmen, wenn die Voraussetzungen für die Lötung dies erfordern oder erlauben.

Zur Überwachung des Befluxungsvorgangs und somit der Flussmitteldicke ist eine Überwachungsvorrichtung 10, mit mehreren Überwachungs-Einheiten 10a, 10b, 10c vorgesehen. Bezug nehmend auf Fig. 2 ist als erste Überwachungs-Einheit 10a ein als Sender 11 dienender Laser und ein Empfänger 12 vorgesehen. Diese erste Überwachungs-Einheit 10a überwacht bei jedem Sprühzyklus, ob ein Flussmittel-Sprühstrahl vorhanden ist. Fehlt der Flussmittel-Sprühstrahl, so wird das Band gestoppt und ein Warnsignal gegeben. Eine entsprechende Überwachungs-Einheit (nicht dargestellt) ist auch noppenseitig vorgesehen.

Eine zweite Überwachungs-Einheit 10b überwacht, ob ausreichend Flussmittel 3 auf der Noppenseite vorhanden ist, wobei der zu dieser Einheit gehörende Laser am Ausgang des Trockners vorgesehen ist. Hierbei erfolgt eine Überwachung dahingehend, ob eine Weißfärbung vorhanden ist oder nicht. Das Ergebnis der Überwachung, d.h. ob ein vorgegebener Weißton, also ausreichend Flussmittel aufgebracht wurde, oder kein ausreichender Weißton, also die Noppenseite noch silbern/aluminiumfarben ist und somit nicht ausreichend Flussmittel aufgebracht wurde, vorliegt, wird digitalisiert und an die Überwachungsvorrichtung 10 gesendet. Von dieser wird ein entsprechendes Signal abgegeben, so dass gegebenenfalls das entsprechende Teil ausgesondert und die Sprühstrahlstärke entsprechend korrigiert werden oder eine sonstige Fehlfunktion behoben werden kann.

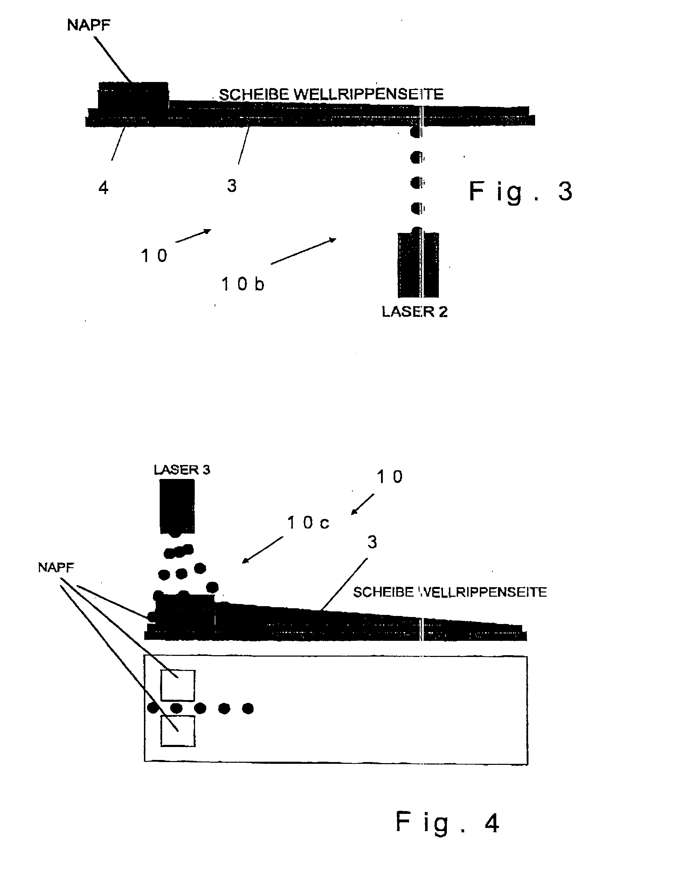

Ferner ist eine dritte Überwachungs-Einheit 10c vorgesehen, die überwacht, ob auf der Wellrippenseite im in Fig. 4 gekennzeichneten Bereich, ausreichend Flussmittel 3 vorhanden ist. Hierbei ist ein 2-Kanal-Laser vorgesehen, dessen erster Kanal ein digitalisierter Weißton ist und einem Schichtgewicht von beispielsweise 0,02 bis 0,05 g/cm² entspricht. Der zweite Kanal ist ein anderer digitalisierter Weißton und entspricht einem Schichtgewicht von beispielsweise 0,05 - 0,1 g/cm².

### Die Regelung erfolgt hierbei folgendermaßen:

Spricht der erste Kanal an, d.h. das vorgegebene Schichtgewicht wird überschritten, so erfolgt eine statistiosche Meßwertauswertung einer Anzahl von darauffolgenden Messwerten/Messungen. In Abhängigkeit der Auswertung dieser Messwerte wird eine automatische Einstellung der Spritzdauer und/oder Spritzmenge eingestellt, wie beispielsweise eine Spritzzeitreduzierung, d.h. es kann eine Verringerung der aufgetragenen Flussmittelmenge bewirkt werden. Erfolgen mehrere, beispielsweise vier aufeinanderfolgende Messungen, die mit ihren Messwerten im Sollwerteberich liegen, so wird die statistische Auswertung neu begonnen werden.

Spricht der zweite Kanal einmal an, so ist die Flussmittelmenge zu hoch. Die Flussmittelmenge wird automatisch nach unten korrigiert.

Ein entsprechender 2-Kanal-Laser kann auch noppenseitig verwendet werden, um auch dort die Beschichtungsdicke mit Flussmittel zu optimieren.

Fig. 5 zeigt eine Ampelanlage, die zur besseren Überwachbarkeit des Transportbandes vorzugsweise oberhalb des Abstapelroboters angeordnet ist. Diese macht die Signale der Überwachungsvorrichtung 10 optisch und akustisch sichtbar. Bezüglich der einzelnen Funktionen sei auf die Beschreibung in Fig. 5 verwiesen.

Erfindungsgemäß kann es vorteilhaft sein, wenn die Flussmittelmenge über das Bauteil verteilt inhomogen verteilt ist. Dabei können Bereiche mit einer gleichmässigen Verteilung neben Bereichen mit einer ungleichmässigen Verteilung und/oder mit gleicher Verteilung mit unterschiedlicher Menge vorliegen. Dabei kann beispielsweise ein Bereich mit 50 Gewichts% neben Bereichen mit 30 Gewichts% und 20 Gewichts% vorliegen. Dies kann vorteilhaft sein bei Wärmetauscghern mit einem Sammelkasten auf einer Seite. Auch kann es erfindungsgemäß vorteilhaft sein, wenn zwei Bereiche mit ca. 40 Gewichts% neben einem Bereich mit 20 Gewichts% oder zwei Bereichen mit jeweils 10 Gewichts% vorliegen. Dies kann zweckmässig sein bei einem Wärmetauscher mit zwei Sammelkasten auf zwei gegenüberliegenden Seiten.

### Bezugszeichenliste

- 1: Befluxungs-Vorrichtung
- 2: Werkstück
- 3: Flussmittel
- 4: napfförmiger Bereich
- 5: Sprühpistole
- 10: Überwachungsvorrichtung
- 10a: erste Überwachungs-Einheit
- 10b: zweite Überwachungs-Einheit
- 10c: dritte Überwachungs-Einheit
- 11: Sender
- 12: Empfänger

## Patentansprüche

1. Vorrichtung zum automatisierten Aufbringen von Flussmittel auf eine Materialoberfläche mit zumindest einer Sprühvorrichtung, **dadurch gekennzeichnet, dass** das Flussmittel auf der Oberfläche ungleichmäßig oder inhomogen oder heterogen verteilt wird, wobei vorzugsweise zumindest eine Zone mit mehr aufgebrachtem Flussmittel und zumindest eine Zone mit reduziertem aufgebrachtem Flussmittel vorliegt.

2. Vorrichtung nach Anspruch 1, **dadurch gekennzeichnet, daß** eine, zwei, drei oder mehr Sprühvorrichtungen Verwendung finden.

3. Vorrichtung zum automatisierten Aufbringen von Flussmittel auf eine Materialoberfläche mit zumindest einer Sprühvorrichtung, insbesondere nach einem der Ansprüche 1 bis 2, **dadurch gekennzeichnet, dass** die zumindest eine Sprühvorrichtung in einem Winkel von 30° bis 60° zur Materialoberfläche geneigt, und gegebenenfalls in einem Bereich in der Nähe eines Randes der Materialoberfläche angeordnet ist.

4. Vorrichtung nach Anspruch 3, **dadurch gekennzeichnet, dass** die Sprühvorrichtung in einem Winkel von 40° zur Materialoberfläche angeordnet ist.

5. Vorrichtung nach einem der vorstehenden Ansprüche, **dadurch gekennzeichnet, dass** die Materialoberfläche horizontal angeordnet ist.

6. Vorrichtung nach einem der vorstehenden Ansprüche, **dadurch gekennzeichnet, dass** die Materialoberfläche durch eine Seite einer Scheibe von einem Scheibenwärmetauscher, wie Scheibenkühler oder Scheibenverdampfer, gebildet ist, wobei die Sprühvorrichtung auf deren napfseitiger Seite angeordnet ist.

7. Vorrichtung nach Anspruch 6, **dadurch gekennzeichnet, dass** die Materialoberfläche durch die wellrippenseitige Seite der Scheibe gebildet ist.

8. Vorrichtung nach Anspruch 6, **dadurch gekennzeichnet, dass** die Materialoberfläche durch die Noppenseite der Scheibe gebildet ist.

9. Vorrichtung nach einem der vorstehenden Ansprüche, **dadurch gekennzeichnet, dass** die Vorrichtung eine Überwachungsvorrichtung (10) aufweist, welche der Kontrolle der Flussmittelbeschichtung dient.

10. Vorrichtung nach Anspruch 9, **dadurch gekennzeichnet, dass** die Überwachungsvorrichtung (10) mehrere Überwachungs-Einheiten aufweist (10a, 10b, 10c).

11. Vorrichtung nach einem der vorhergehenden Ansprüche, **dadurch gekennzeichnet, dass** die Überwachungsvorrichtung (10) eine optische Überwachungsvorrichtung (10) ist.

12. Vorrichtung nach einem der Ansprüche 9 bis 11, **dadurch gekennzeichnet, dass** die Überwachungsvorrichtung (10) eine den Sprühstrahl überwachende Überwachungs-Einheit (10a) aufweist.

13. Vorrichtung nach Anspruch 9 bis 12, **dadurch gekennzeichnet, daß** die Flussmittelmenge in der für den Fertigungsprozeß erforderlichen Zeit detektiert, ausgewertet und der Prozess nachgeregelt wird.

14. Vorrichtung nach einem der Ansprüche 9 bis 13, **dadurch gekennzeichnet, dass** die Überwachungsvorrichtung (10) eine die Schichtdicke überwachende Überwachungs-Einheit (10b, 10c) aufweist.

15. Verfahren zum Aufbringen eines Flussmittels (3) zum Hartlöten von Teilen, insbesondere auf der Basis von Aluminium als Grundmaterial, unter Verwendung zumindest einer Sprühvorrichtung, **dadurch gekennzeichnet, dass** der von zumindest einer Sprühvorrichtung abgegebene Sprühstrahl in einem Winkel ungleich 90° bezüglich der Materialoberfläche geneigt abgegeben wird, wobei gegebenenfalls ein Teil des Sprühstrahles nicht die Materialoberfläche trifft.

16. Verfahren zum Aufbringen eines Flussmittels (3) zum Hartlöten von Teilen, insbesondere auf der Basis von Aluminium als Grundmaterial, unter Verwendung zumindest zweier Sprühvorrichtung, **dadurch gekennzeichnet, dass** der von zumindest zwei Sprühdüsen abgegebene Sprühstrahl mit unterschiedlicher Sprühintensität abgegeben wird.

17. Verfahren zum Aufbringen eines Flussmittels zum Hartlöten von Teilen, insbesondere auf der Basis von Aluminium als Grundmaterial, unter Verwendung einer Sprühdüse, **dadurch gekennzeichnet, dass** eine Vorrichtung nach einem der Ansprüche 1 bis 14 verwendet wird.

18. Verfahren nach Anspruch 15, 16 oder 17, **dadurch gekennzeichnet, dass** 0,02 bis 0,1 g Flussmittel (3) je Quadratzentimeter aufgebracht werden.

19. Verfahren nach einem der Ansprüche 13 bis 16, **dadurch gekennzeichnet, dass** mittels einer Überwachungsvorrichtung (10) die Menge des aufgebrachten Flussmittels (3) überwacht wird.

20. Wärmetauscher bestehend aus einer Vielzahl von Bauteilen, die miteinander verlötbar sind, wobei zur Aufbringung eines Flussmittels ein Verfahren und/oder eine Vorrichtung der vorgehenden Ansprüche Anwendung findet.
